# EUROPÄISCHE PATENTSCHRIFT

(11) **EP 3 264 125 B1**
(45) Veröffentlichungstag und Bekanntmachung des Hinweises auf die Patenterteilung: **16.09.2020**
(21) Anmeldenummer: 17179069.4
(22) Anmeldetag: 30.06.2017
(51) Int. Cl.: G01R 33/34, G01R 33/30, G01R 33/46

(54) **HF-SPULENANORDNUNG FÜR NMR**
HF COIL ASSEMBLY FOR NMR
SYSTÈME DE BOBINE HF POUR RMN

(30) Priorität: 01.07.2016 DE 102016212018
(43) Veröffentlichungstag der Anmeldung: 03.01.2018
(73) Patentinhaber: Bruker Switzerland AG, 8117 Fällanden (CH)
(72) Erfinder: Hassan, Alia, 8122 Binz (CH); Freytag, Nicolas, 8122 Binz (CH)
(74) Vertreter: Kohler Schmid Möbus Patentanwälte

(56) Entgegenhaltungen:
- JP-A- S63 317 143
- US-A1- 2007 285 096
- US-B2- 6 806 713
- J. Thomas Vaughan ET AL: "Detection Coils for MRS" In: "eMagRes", 15. Juni 2016 (2016-06-15), John Wiley & Sons, Ltd, Chichester, UK, XP055419813, ISBN: 978-0-470-05821-3 Seiten 1363-1376, DOI: 10.1002/9780470034590.emrstm1465, * Seite 1368 - Seite 1370 * * *

## Beschreibung

Die vorliegende Erfindung betrifft ein MAS-NMR-Magnetresonanzgerät mit einer Hochfrequenz(HF)-Spulenanordnung zur Erzeugung mindestens zweier unabhängiger magnetischer Wechselfelder in einem Untersuchungsvolumen eines Magnetresonanzgeräts, umfassend ein erstes Spulenpaar aus Sattelspulen mit Längs-Leiterelementen und Bogen-Leiterelementen die entlang einer gemeinsamen geometrischen Mantelfläche eines Kreiszylinders mit einer Zylinderachse angeordnet sind. Die Erfindung betrifft auch ein Verfahren zur Durchführung einer NMR-Messung mit dem MAS-NMR-Magnetresonanzgerät.

Ein obengenanntes MAS-NMR-Magnetresonanzgerät ist aus US 6806713 B2 bekannt.

### Hintergrund der Erfindung

NMR-Spektroskopie (NMR steht für Nuclear Magnetic Resonance, Kernspinresonanz) ist ein Verfahren der instrumentellen Analytik, mit dem insbesondere die chemische Zusammensetzung von Proben bestimmt werden kann. Dabei werden Hochfrequenz-Pulse in die Probe, die sich in einem starken, homogenen statischen Magnetfeld *B*₀ befindet, eingestrahlt, und die elektromagnetische Reaktion der Probe wird vermessen. Bei der Festkörper NMR-Spektroskopie ist es bekannt, zur Verringerung von Linienverbreiterungen aufgrund anisotroper Wechselwirkungen, die Probe mit hoher Drehzahl um eine Drehachse zu rotieren. Dazu wird die Drehachse unter dem sogenannten "magischen Winkel" von *θ*ₘ = arccos(√⅓) ≈ 54,74° geneigt zum homogenen statischen Magnetfeld angeordnet. Diese Messtechnik wird üblicherweise als "magic-angle spinning" (MAS) bezeichnet. Der Winkel *θ*ₘ ist eine Lösung des zweite-Ordnung Legendrepolynoms *P*₂(cos(*θ*ₘ)) = 0, so dass alle Wechselwirkungen die von diesem Legendrepolynoms abhängen bei Rotation um eine Achse unter diesem Winkel zum Magnetfeld über die Zeit ausgemittelt werden. Dies ist der Fall für drei wichtige Wechselwirkungen in der Materie: der dipolaren Kopplung, der chemischen Shift Anisotropie und der Quadrupolwechselwirkung erster Ordnung. Da für nicht-einkristalline Proben die Kristallrichtungen einzelner Kristallite zufällig zum statischen Feld stehen wird die Auslöschung der Wechselwirkung durch eine ausreichend schnelle Rotation der Probe im magischen Winkel erzielt. Somit lässt sich eine Linienverbreiterung durch diese Wechselwirkungen signifikant reduzieren, im Idealfall sogar bis zur natürlichen Linienbreite.

MAS-NMR-Messsonden erlauben die Anwendung von hochauflösender NMR-Spektroskopie auf feste, pulverförmige oder semisoliden (gelförmigen oder pastösen) Probensubstanzen. Dazu wird die Probe in einen kreiszylinderförmigen Probenbehälter, den sogenannten Rotor gefüllt, der während der Messung mittels komprimierter Gase in einem Stator zu sehr hohen Drehzahlen mit einer Rotationsfrequenz im Bereich einiger kHz bis über hundert kHz rotiert wird. Die radiale Lagerung wird durch Luftlager im Stator sichergestellt ebenso wie eine durch Luftströmung erzeugte Haltekraft den Rotor in seiner axialen Position im Stator hält.

Die Probe ist von mindestens einer Sende- und/oder Empfangsspule umgeben, mittels derer hochfrequente (HF) magnetische Wechselfelder *B*_{1*i*} im Messvolumen eingestrahlt werden können, deren Frequenz ω*ᵢ* auf die Resonanzfrequenz eines Kernes im statischen Magnetfeld *B*₀ angepasst ist. In der Regel werden Messsonden so konzipiert, dass mindestens zwei verschiedene Frequenzen gesendet und empfangen werden können.

Viele Festkörper-NMR Experimente verwenden die sogenannte Kreuzpolarisation (cross polarization, CP) zur Erhöhung der Empfindlichkeit. Die CP ist eine NMR-Standardtechnik zum Verstärken und Zuordnen von NMR-Linien, bei der selten vorkommenden Spins *S* (z.B. Spins der ¹³C-Kerne) mit häufigen Spins *I* (z.B. Spins der ¹H-Kerne) gekoppelt werden. Dazu werden gleichzeitig zwei magnetische Wechselfelder B_{1*I*} und *B*_{1*S*} je mit der Resonanzfrequenz ω*_{I}* und ω*_{S}* der jeweiligen Spins auf die Probe eingestrahlt, wobei die beiden magnetischen Wechselfelder zusätzliche die sogenannte Hartmann-Hahn-Bedingung (HHB) zumindest näherungsweise erfüllen müssen. Die HHB ist erfüllt, wenn die Intensitäten der Spinlock-Felder B_{1*I*} und *B*_{1*S*} die Bedingung γ*_{I}* B_{1*I*} = γ*_{S} B*_{1*S*} erfüllen, wobei γ*_{I}* und γ*_{S}* die gyromagnetischen Verhältnisse der jeweiligen Kernspins sind. Dann ist ein optimaler Polarisationstransfer zwischen den zwei Kernarten *I* und *S* durch *J*-Kreuzpolarisation möglich. Die CP ist ein Doppelresonanzexperiment, das meist zwischen ¹H (*I*) und ¹³C (*S*) durchgeführt wird.

In Festkörpern wird mittels Kreuzpolarisation das Signal von *S* verstärkt, indem während einer Kontaktzeit *I* im SpinLock (Spinlocking) gehalten wird, *S* zur Sättigung gebracht wird und die "heißen" und "kalten" Spins koppeln (Spintemperatur), so dass ein Magnetisierungstransfer stattfindet. Dabei wird der häufige Kern *I* angeregt und seine Energie auf den detektierten Kernspin S transferiert, indem auf beiden Kanälen je ein RF-Puls niedriger Leistung angelegt wird. Die HF-Leistung dieser beiden Pulse muss so eingestellt werden, dass die Übergangsenergie für beide Kerne dieselbe ist. Für das Beispiel des ¹H ¹³C Polarisationstransfers muss das hochfrequente Magnetfeld *B*₁ circa vier Mal schwächer für den Protonenkanal ausfallen als für den Kohlenstoffkanal. Die Effizienz des Polarisationstransfers ist stark von der Einhaltung der Hartmann-Hahn Bedingungen abhängig. Insbesondere ist es wichtig, dass die Hartmann-Hahn-Bedingung an möglichst vielen Stellen im Messvolumen innerhalb eines Toleranzbereichs erfüllt ist, der von verschiedenen experimentellen Parametern, u.a. von der MAS-Rotationsfrequenz abhängt.

Ein Experiment mit besonders engem Toleranzbereich für das Erfüllen der HHB, das insbesondere in der Festkörper-NMR biologischer Substanzen eine große Bedeutung hat, ist das sogenannte Doppel-CP-Experiment (DCP). Bei diesem Experiment werden nacheinander zwei CP Schritte durchgeführt. Üblicherweise wird in einem ersten Schritt die Polarisation der Protonen auf einen Typ X-Kerne transferiert (um die Empfindlichkeit zu erhöhen), ein zweiter Schritt transferiert auf einen anderen (Y) Kern um die dipolare Kopplung zwischen X und Y Kernen zu bestimmen. Die Sequenz des Transfers ist prinzipiell beliebig, in der Regel wird jedoch von ¹H zu ¹⁵N und schließlich zu ¹³C transferiert, welches schlussendlich detektiert wird.

Die Toleranzbereiche der HHB für dieses Experiment sind extrem scharf, so dass eine exakte Kalibration der *B*₁ᵢ-Feldstärken notwendig ist. Des Weiteren hängt die Effizienz extrem davon ab, dass alle drei beteiligten *B*_{1*i*} -Felder, insbesondere die magnetische Wechselfelder für die Anregung der ¹⁵N und ¹³C Kerne im Messvolumen geeignet zusammenspielen.

### Begriffe

Im Folgenden wird für wichtige Begriffe definiert, wie sie der vorliegenden Beschreibung und in den Ansprüchen verwendet werden.

An einem Kreiszylinders nennen wir eine Richtung parallel zur Zylinderachse eine *axiale* Richtung, eine Richtung entlang einem Umfang der Mantelfläche des Kreiszylinders eine *azimutale* Richtung und eine Richtung zur Achse oder von der Achse weg eine *radiale* Richtung. Positionen, Ausdehnungen und Winkel werden analog als axial, azimutal und radial bezeichnet.

Eine Richtung auf der Mantelfläche, die einer Kombination von axialer und azimutaler Richtung entspricht, d.h. in Richtung einer lokalen Tangente an eine Schraubenlinie auf der Mantelfläche liegt, nennen wir *diagonal.*

Unter einer *Spule* verstehen wir einen durchgehenden elektrischen Leiter oder eine resonante Struktur mit Leiterabschnitten und kapazitiven wirkenden Abschnitten und Bauelementen, die in mindestens einer Windung um ein Gebiet herum angeordnet ist.

Unter einer *Sattelspule* verstehen wir eine Spule, die dem Umfang einer gedachten, über einen Zylindermantel gebogenen Fläche entlang angeordnet ist. Diese Fläche kann in der Abwicklung beispielsweise die Form eines Rechtecks haben, diese Fläche kann aber auch ein beliebiges Vieleck sein oder abgerundete Ecken aufweisen. Zur Festlegung einer Lage oder einer Abmessung der Spule ist im Fall von breiten Leiterbahnen oder im Fall von mehreren Windungen der Stromschwerpunkt auf einer Leiterbahn oder der Stromschwerpunkt von benachbarten Leiterelementen mehrerer Windungen in Betracht zu ziehen.

Als *Bogen-Leiterelement* bezeichnen wir ein entlang einem Umfang eines Kreiszylinders verlaufendes, im Wesentlichen azimutal ausgedehntes, Leiterelement.

Als *Längs-Leiterelement* bezeichnen wir ein entlang einer Mantelfläche eines Kreiszylinders verlaufendes, im Wesentlichen axial ausgedehntes, Leiterelement.

Als *Diagonal-Leiterelement* bezeichnen wir ein entlang einer Mantelfläche eines Kreiszylinders verlaufendes, im Wesentlichen im oben definierten Sinn diagonal ausgedehntes, Leiterelement.

Unter einer *Solenoidspule* verstehen wir eine Spule, deren Windungen im Wesentlichen in Form einer Schraubenlinie mit geringerer Steigung entlang einer Mantelfläche eines Zylinders verlaufen.

Unter der *Achse einer Spule* verstehen wir eine Achse durch das Gebiet, um welche die Windungen der Spule angeordnet sind und bezüglich der ein Windungssinn der Spule definiert ist. Im Fall einer Solenoidspule ist die Achse der Spule die Zylinderachse. Im Fall einer Sattelspule steht die Achse der Spule senkrecht auf der Zylinderachse. Ein von der stromdurchflossenen Spule erzeugtes Magnetfeld ist im Zentrum der Spule ungefähr entlang der Achsenrichtung der Achse der Spule orientiert.

### Stand der Technik

In der Regel werden NMR Messsonden in supraleitenden NMR Magnetsystemen eingesetzt, bei denen das homogene statische Magnetfeld *B*₀, das die z-Achse des Laborkoordinatensystems vorgibt, entlang einer "Bohrung" orientiert ist.

Die zu analysierenden Proben, bestehend aus flüssigen, pulverförmigen, gelartigen Substanzen, aber auch Gewebeproben, Einkristallen, Gläsern oder Mischungen verschiedener Stoffe, werden in der Regel in zylinderförmige, insbesondere Kreiszylinderförmige, Behälter gefüllt. Dieser Probenbehälter wird in eine für die Probenaufnahme vorgesehene Aussparung in der Messsonde eingeführt. Die Zylinderachse des Probenbehälters steht üblicherweise entweder parallel, orthogonal oder im magischen Winkel *θ*ₘ = arccos(√⅓) ≈ 54,74° zu *B*₀. Die Proben werden von i.d.R. zylinderförmigen RF-Spulenanordnungen umgeben, die üblicherweise aus Sattelspulen, Solenoidspulen und/oder Resonatoren bestehen, wobei insbesondere Birdcage-Resonatoren und Alderman-Grant-Resonatoren Verwendung finden.

Es ist üblich, innerhalb eines NMR-Experiments dieselbe Spule einmal zum Anregen der Kernspins, also als Sendespule, einzusetzen und in einer späteren Phase des NMR-Experiments zur Detektion von Signalen, also als Empfangsspule einzusetzen. Dabei werden die entsprechenden HF-Pfade des NMR-Spektrometers entsprechend von einem HF-Sender auf einen Vorverstärker und HF-Empfänger umgeschaltet. Entsprechende Umschaltvorrichtungen sind bekannt.

Aufgrund der extrem kleinen Signale, die bei NMR-Experimenten gemessen werden müssen, hat oft die Empfindlichkeit in der Detektionsphase ein besonders hohes Gewicht beim Design einer Spulenanordnung. In der Regel hat eine NMR-Messsonde eine, eventuell auch zwei bevorzugte Messfrequenzen, die zur Detektion eingesetzt werden. Weitere Messfrequenzen werden hauptsächlich zum Senden von Entkopplungspulsen und für Polarisationstransfers verwendet. Um den simultanen Betrieb auf mehreren Sende- oder Empfangsfrequenzen zu ermöglichen werden i.d.R. zwei radial ineinander liegende Spulenanordnungen verwendet. Dabei wird zumindest eine der Detektions-Messfrequenzen auf der inneren Spulenanordnung platziert und versucht, die Verluste dieser Spulenanordnungen zu minimieren. Dies führt zur Optimierung der Empfindlichkeit der Messsonde bei der Detektion.

Es sind insbesondere in der Festkörper-NMR auch Messsonden üblich, bei denen mehrere Resonanzfrequenzen auf einer einzigen Detektionsspule abgestimmt werden, was jedoch große Einbußen in der Performanz bei mehr als zwei Resonanzfrequenzen zur Folge hat. Das Einhalten einer Reihe von Randbedingungen führt zu großen Einbußen in der Performanz von CP Experimenten, insbesondere bei DCP Experimenten.

J. Thomas Vaughan et al. offenbaren in "Detection Coils for MRS" in eMagRes, Vol. 5, 2016, pp 1362-1376 eine HF-Spulenanordnung, die ausschließlich in Zusammenhang mit einem ***MRS-Gerät*** dargestellt und beschrieben ist. Ein Hinweis auf ein ***MAS-NMR-Gerät*** ist nicht zu entnehmen.

Aus der US 6806713 B2 ist eine NMR Messsonde bekannt, bei dem bis zu drei koaxial zu einer MAS-Rotationsachse angeordnete Spulen verwendet werden, wobei mindestens zwei dieser Spulen auf derselben Messfrequenz abgestimmt sind und in Quadratur betrieben werden. Eine solche Messsonde minimiert die zur Erzeugung von breitbandigen RF-Pulsen notwendige Leistung und maximiert die Empfindlichkeit für die Detektion des in Quadratur betriebenen Messkanals. Die Spulenanordnung in dieser Messsonde löst das Problem, dass nur die zum statischen Magnetfeld senkrecht stehenden Komponenten der magnetischen Wechselfelder für die Anregung der Kernspins wirksam sind und dass die zu empfangenden magnetischen Wechselfelder ebenfalls senkrecht zum statischen Magnetfeld stehen. Die Spulen gemäß US 6806713 B2 werden so verschaltet und betrieben, dass sich die von ihnen erzeugten magnetischen Wechselfelder zu einem magnetischen Wechselfeld mit großer wirksamer Komponente aufaddieren, resp. in der Empfangsphase eines NMR-Experiments die von den Kernspins erzeugten magnetischen Wechselfelder optimal detektieren.

Ungelöst bleibt in der genannten Spulenanordnung die Problematik der Kreuzpolarisations-Effizienz, insbesondere der Kreuzpolarisations-Effizienz in DCP Experimenten. Daher stellt eine Lösung, wie in der US 6806713 B2 präsentiert, keine Maximierung der Messsonden-Empfindlichkeit für realistische Experimente dar.

### Aufgabe der Erfindung

Die Aufgabe der vorliegenden Erfindung besteht darin, eine alternative HF-Spulenanordnung zur Erzeugung mindestens zweier unabhängiger magnetischer Wechselfelder in einem Untersuchungsvolumen eines Magnetresonanzgeräts zur Verfügung zu stellen, die einen Nachteil des Stands der Technik überwindet. Insbesondere ist eine Aufgabe der vorliegenden Erfindung, eine HF-Spulenanordnung mit hoher Kreuzpolarisations-Effizienz (CP-Effizienz) zu schaffen.

### Kurze Beschreibung der Erfindung

Diese Aufgabe wird durch das MAS-NMR-Magnetresonanzgerät gemäß Anspruch 1 gelöst.

Die HF-Spulenanordnung des erfindungsgemäßen MAS-NMR-Magnetresonanzgeräts dient der Erzeugung mindestens zweier unabhängiger magnetischer Wechselfelder in einem Untersuchungsvolumen eines Magnetresonanzgeräts. Sie umfasst zwei Spulenpaare aus Sattelspulen je mit Längs-Leiterelementen und Bogen-Leiterelementen, die entlang einer gemeinsamen geometrischen Mantelfläche eines Kreiszylinders mit einer Zylinderachse angeordnet sind. Dabei ist eine erste Gruppe der Bogen-Leiterelemente und Längs-Leiterelemente hochfrequenzmäßig zur Bildung des ersten Spulenpaars mit sich in Bezug auf die Zylinderachse gegenüberliegenden Sattelspulen verschaltet. Dabei ist weiter eine zweite Gruppe der Bogen-Leiterelemente und Längs-Leiterelemente hochfrequenzmäßig zur Bildung des zweiten Spulenpaars mit sich in Bezug auf die Zylinderachse gegenüberliegenden, Sattelspulen verschaltet. Die axiale Position und Ausdehnung bezüglich der Zylinderachse des ersten und des zweiten Spulenpaars sind gleich. Das erste und zweite Spulenpaar überlappen in azimutaler Richtung und in den Sattelspulen des ersten und/oder zweiten Spulenpaars sind Brückenelemente angeordnet, welche ein Leiterelement des jeweils anderen Spulenpaars überqueren.

Die HF-Spulenanordnung gemäß der vorliegenden Erfindung kann kostengünstig und mit einfachen, ohne weiteres zur Verfügung stehenden technischen Mitteln, aufgebaut werden. Die HF-Spulenanordnung ermöglicht, durch Beaufschlagung der beiden Spulenpaare in der HF-Spulenanordnung je mit einem hochfrequenten elektrischen Signal, zwei unabhängige hochfrequente magnetische Wechselfelder in einem Messvolumen zu erzeugen, die bei gleichzeitiger Einstrahlung auf eine Probe zu einer hohen Kreuzpolarisations-Effizienz führen.

Die Erfinder haben erkannt, dass bei der in der Erfindung verwendeten HF-Spulenanordnung die zwei mittels den beiden Spulenpaaren erzeugten magnetischen Wechselfelder, im Messvolumen weitgehend zu einander proportionale Feldstärkenverteilungen aufweisen. Dadurch wird erreicht, dass mit einer Einstellung des Verhältnisses der Sendeleistungen, so dass wenn die HHB für eine Stelle im Messvolumen erfüllt ist, die HHB im ganzen Messvolumen mit nur kleiner Abweichung erfüllt ist. Oder anders ausgedrückt: die Feldstärkeverteilung des vom ersten Spulenpaar erzeugten magnetischen Wechselfelds stimmt in ihrer dreidimensionalen Form und Lage mit der Feldstärkeverteilung der vom zweiten Spulenpaar erzeugten magnetischen Wechselfelder überein. Unter der Feldstärkeverteilung verstehen wir dabei die Positionsabhängigkeit der Amplituden der magnetischen Wechselfelder.

Die unabhängig voneinander erzeugbaren magnetischen Wechselfelder können sich beispielsweise durch verschiedene Frequenzen oder verschiedene Phasenlagen unterscheiden. Insbesondere können auch im Fall zweier verschiedener Sendefrequenzen im Messvolumen weitgehend identische Feldstärkenverteilungen für die beiden magnetischen Wechselfelder erreicht werden, ohne hierbei wesentliche Einbußen in der Performanz der Messsonde für andere Parameter hinnehmen zu müssen.

In einer Ausführungsform der HF-Spulenanordnung ist mindestens eines der Brückenelemente als elektrisch leitendes Element ausgebildet. Solche Brückenelemente können beispielsweise als Bonddraht oder als gebogenes Metallblech ausgeführt sein.

In einer Ausführungsform der HF-Spulenanordnung ist mindestens eines der Brückenelemente als Kondensator, insbesondere als Keramik-Vielschicht-Kondensator-Chip, ausgebildet.

In einer Ausführungsform der HF-Spulenanordnung umfasst mindestens ein Spulenpaar Diagonal-Leiterelemente, die je entlang einer Schraubenlinie auf der Mantelfläche ausgedehnt sind. Diagonal-Leiterelement können beispielsweise Längs-Leiterelemente mit Bogen-Leiterelementen verbinden.

In einer Ausführungsform der HF-Spulenanordnung überqueren vorzugsweise diagonal angeordnete Brückenelemente des einen Spulenpaars jeweils Diagonal-Leiterelemente des anderen Spulenpaars. Diese Ausführungsform ermöglicht eine kompakte Anordnung der Kreuzungsstellen.

In einer Ausführungsform der HF-Spulenanordnung sind Bogen-Leiterelemente des ersten Spulenpaars und Bogen-Leiterelemente des zweiten Spulenpaars axial aufeinander ausgerichtet.

In einer Ausführungsform der HF-Spulenanordnung beträgt der azimutale Öffnungswinkel der Sattelspulen mindestens eines Spulenpaars zwischen 100° und 140°, insbesondere 120°. Im Fall von Spulen mit mehreren Windungen ist der Stromschwerpunkt benachbarter Leiter zur Bestimmung des azimutalen Öffnungswinkels zu berücksichtigen. In dieser Ausführungsform werden gleichzeitig mit der hohen CP-Effizienz räumlich gleichförmige, d.h. homogene, Verteilungen der erzeugten magnetischen Wechselfelder erreicht. Allgemein führt ein nah am Winkel 120° gewählter azimutaler Öffnungswinkel, z.B. in einem Bereich zwischen 110° und 130° oder zwischen 115° und 125°, zu besserer Homogenität und zu höherer CP-Effizienz.

In einer Ausführungsform der HF-Spulenanordnung sind die Spulenpaare in Bezug aufeinander um 90° um die Zylinderachse gedreht angeordnet. In dieser Ausführungsform kann durch die geometrische Anordnung der beiden Spulenpaare eine HF-technische Entkopplung der Spulenpaare erreicht werden.

In einer Ausführungsform der HF-Spulenanordnung haben die Leiterelemente des ersten Spulenpaars und des zweiten Spulenpaars die gleiche Form und sind in gleicher Form angeordnet. In dieser Ausführungsform sind die Bogen-Leiterelemente, die Längs-Leiterelemente und allenfalls die Diagonal-Leiterelemente des zweiten Spulenpaar sozusagen eine in azimutaler Richtung gedrehte Kopie der entsprechenden Leiterelemente des ersten Spulenpaares.

In einer weiteren Ausführungsform ist die HF-Spulenanordnung auf einem Spulenträger mit einer Außenfläche, die abschnittsweise mit der geometrischen Mantelfläche des Kreiszylinders identisch ist, angeordnet. Die Leiterelemente können beispielsweise durch Strukturieren, beispielsweise durch Ätzen, einer metallischen Beschichtung des Spulenträgers hergestellt sein. Die Spulen können sich auch einfach am Spulenträger abstützen.

In einer Ausführungsform der HF-Spulenanordnung umfasst der Spulenträger mindestens eines der folgenden Materialien: Saphir, Glas, Quarz, ein Fluoropolymer, insbesondere Polytetrafluoräthylen, eine Keramik, insbesondere Aluminiumoxid, Magnesiumoxid oder Bornitrid. In dieser Ausführungsform wird der dielektrische Verlust der Spulenanordnung minimal gehalten, was zu hoher Empfindlichkeit beim Empfangen von Signalen beiträgt.

In einer Ausführungsform der HF-Spulenanordnung sind die Sattelspulen formstabile freitragende Spulen. In dieser Ausführungsform wird kein Spulenträger benötigt und es steht entweder mehr Messvolumen im Innern der Spulenanordnung oder Volumen für zusätzliche Spulen zur Verfügung.

In einer Ausführungsform der HF-Spulenanordnung umfasst die HF-Spulenanordnung zusätzlich eine Solenoidspule mit Achsenrichtung koaxial zur Zylinderachse. In dieser Ausführungsform steht eine dritte Spule zur Verfügung, mit der ein drittes magnetisches Wechselfeld erzeugt werden kann. Diese Ausführungsform ermöglicht Doppel-CP-Experimente. Die Solenoidspule kann einen größeren oder einen kleineren Radius als der Radius des Kreiszylinders haben, auf dessen Mantelfläche die beiden Sattelspulenpaare angeordnet sind.

Die beiden Spulenpaare der HF-Spulenanordnung sind zur Erzeugung magnetischer Wechselfelder zweier unterschiedlicher Frequenzen ausgelegt. Die Spulenpaare können durch Verwendung von kapazitiven Bauelementen als resonante Strukturen aufgebaut sein. Die Auslegung von Windungszahlen, Spulendimensionen und Kapazitätswerden erfolgt derart, dass ein resonanter Mode mit homogener Feldverteilung im vorgesehenen Messvolumen in seiner Frequenz der NMR-Resonanzfrequenz eines gewünschten Kernspins entspricht. So kann beispielsweise ein Spulenpaar auf ¹H-Frequenz und das andere auf die ¹³C-Frequenz ausgelegt sein.

In einer Ausführungsform der HF-Spulenanordnung sind in zumindest einem Spulenpaar die beiden Sattelspulen in Serie geschaltet.

In einer Ausführungsform der HF-Spulenanordnung sind in zumindest einem Spulenpaar die beiden Sattelspulen parallel geschaltet.

In einer Ausführungsform gibt es zwei HF-Eingänge, wobei ein erster HF-Eingang über ein erstes Abstimmnetzwerk hochfrequenzmäßig an das erste Spulenpaar angekoppelt ist und wobei ein zweiter HF-Eingang über ein zweites Abstimmnetzwerk hochfrequenzmäßig an das zweite Spulenpaar angekoppelt ist. Diese Ausführungsform ermöglicht eine HF-mäßige Anpassung der einzelnen HF-Kanäle insbesondere auch bei jedem Austausch der Probe im Messvolumen.

In einer Ausführungsform ist zumindest eines der Abstimmnetzwerke über mindestens ein serielles kapazitives Element mit dem jeweiligen Spulenpaar verbunden.

In einer Ausführungsform ist zumindest eines der Abstimmnetzwerke galvanisch getrennt, insbesondere transformatorisch, an das jeweilige Spulenpaar angekoppelt. In dieser Ausführungsform wird die HF-technische Verbindung zum Spulenpaar durch induktiv gekoppelte Spulen erreicht, wobei auf Seite des Spulenpaars eine oder beide Sattelspulen, oder alternativ eine zusätzliche Spule als Kopplungspartner zum Abstimmnetzwerk dienen können. In einer Ausführungsform umfasst die HF-Spulenanordnung zusätzlich eine Solenoidspule mit Achsenrichtung koaxial zur Zylinderachse. In dieser Ausführungsform steht eine dritte Spule zur Verfügung, mit der ein drittes magnetisches Wechselfeld erzeugt werden kann. Diese Ausführungsform der Messsonde ermöglicht Doppel-CP-Experimente.

In einer Ausführungsform hat das Magnetresonanzgerät mindestens ein Drehlager mit zur Zylinderachse koaxialer Drehachse, wobei das mindestens eine Drehlager ausgelegt ist zur drehbaren Halterung einer Probe innerhalb der HF-Spulenanordnung. Diese Drehlager können beispielsweise als pneumatische Lager ausgeführt sein, insbesondere als sogenanntes Bernoulli-Lager.

Das Magnetresonanzgerät hat eine Vorrichtung zur Erzeugung eines statischen Magnetfelds mit einer Magnetfeldrichtung im Untersuchungsvolumen des Magnetresonanzgeräts und eine Anordnung zur Positionierung der Messsonde in einem vorgegebenen Winkel zum statischen Magnetfeld.

Die Zylinderachse ist parallel zur Magnetfeldrichtung angeordnet. Somit erzeugen die beiden Spulenpaare im Betrieb magnetische Wechselfelder, deren Hauptkomponenten im Innern der Spulenanordnung, d.h. im Messvolumen, senkrecht zum statischen Magnetfeld ausgerichtet sind.

Damit wird hohe Effizienz beim Senden und hohe Empfindlichkeit bei der Detektion erreicht.

In einer Ausführungsform des Magnetresonanzgeräts ist die Zylinderachse in einem Winkel zwischen 54.7° und 54.8° zur Magnetfeldrichtung angeordnet. Hierbei handelt es sich um die Ausführungsform für MAS-NMR. Das Magnetresonanzgerät kann beispielsweise auch Mittel zur Feinjustierung des magischen Winkels umfassen.

In einer Variante der zuletzt genannten Ausführungsform des Magnetresonanzgeräts schneiden die Spulenachse des ersten Spulenpaars und die Spulenachse des zweiten Spulenpaars die durch die Magnetfeldrichtung und die Zylinderachse aufgespannte Ebene jeweils in einem 45° Winkel. Diese Ausführungsform hat die Eigenschaft, dass beide Spulenpaare den weitgehend gleichen Anteil der wirksamen Komponente des magnetischen Wechselfelds erzeugen.

In einer Ausführungsform des Magnetresonanzgeräts sind das erste und das zweite Spulenpaar je mit einer ersten und einer zweiten HF-Sendeeinheit gesteuert wirkverbunden. In dieser Ausführungsform können durch geeignete Ansteuerung der Wirkverbindung zwischen der jeweiligen HF-Sendeeinheiten und dem entsprechenden Spulenpaar zeitlich gepulste magnetische Wechselfelder im Innern der HF-Spulenanordnung hervorgerufen werden.

In einem weiteren Aspekt bezieht sich die Erfindung auf ein Verfahren zur Durchführung einer NMR-Messung nach Anspruch 23. Die NMR-Messung wird an einer Probe durchgeführt und bei diesem Verfahren wird ein erfindungsgemäßes MAS-NMR-Magnetresonanzgerät verwendet. Das Verfahren umfasst die Schritte:
- die Probe wird innerhalb der Mantelfläche des Zylinders der HF-Spulenanordnung angeordnet, und
- beide Spulenpaare der HF-Spulenanordnung werden gleichzeitig mit HF-Leistung beaufschlagt.

Ausführungsbeispiele der vorliegenden Erfindung werden nachstehend anhand von Figuren noch näher erläutert. Es zeigen
Fig. 1 eine perspektivische, schematische Ansicht einer erfindungsgemäße HF-Spulenanordnung;
Fig. 2 separat in Figuren 2.a) und 2.b) je eines der Spulenpaare der HF-Spulenanordnung gemäß Fig. 1.

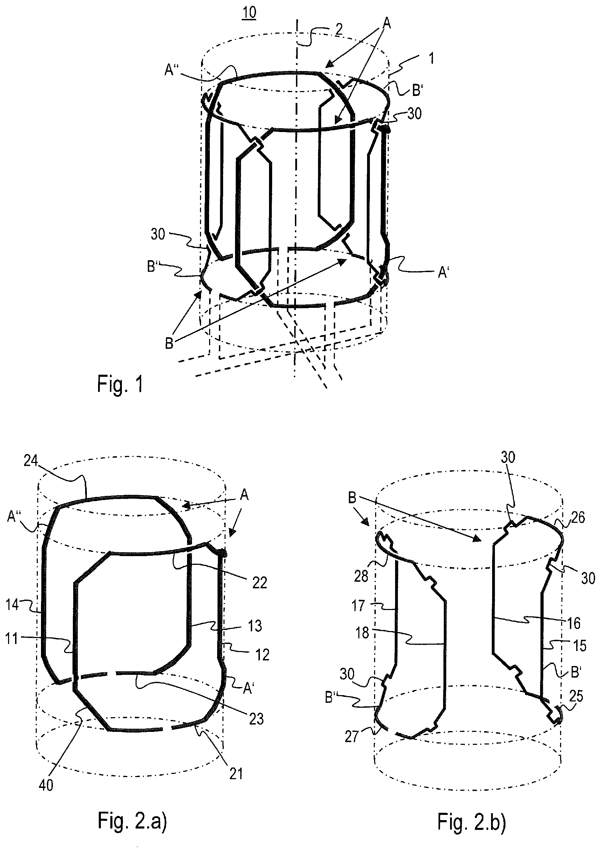

In Fig. 1 ist in perspektivischer, vereinfachter und schematischer Darstellung eine erfindungsgemäße HF-Spulenanordnung 10 gezeigt. Leiterelemente der Spulenanordnung sind entlang der Mantelfläche 1 eines strichpunktiert dargestellten Kreiszylinders mit einer Zylinderachse 2 angeordnet. Längs-Leiterelemente und Bogen-Leiterelemente sind zu Sattelspulen A', A", B', B" zusammengeschaltet. Die Sattelspulen A' und A" liegen sich in Bezug auf die Zylinderachse gegenüber und sind, wie durch gestrichelte Linien schematisch dargestellt, hochfrequenzmäßig miteinander zu einem ersten Spulenpaar A verschaltet. Die Sattelspulen B' und B" liegen sich ebenfalls in Bezug auf die Zylinderachse gegenüber und sind, wie durch gestrichelte Linien schematisch dargestellt, hochfrequenzmäßig miteinander zu einem zweiten Spulenpaar B verschaltet. Die Spulenpaare A und B haben dieselbe axiale Position und Ausdehnung bezüglich der Zylinderachse, was durch strichpunktiert dargestellte Kreise je auf Höhe der Bogen-Leiterelemente verdeutlicht wird. Die Spulenpaare A und B überlappen sich in azimutaler Richtung. In den Sattelspulen sind Brückenelemente 30 angeordnet, welche ein Leiterelement des jeweils anderen Spulenpaars überqueren. In der dargestellten HF-Spulenanordnung sind total acht Brückenelemente vorhanden und es gibt vier Gebiete auf der Mantelfläche des Zylinders, wo sich die Spulenpaare überlappen. Die diagonal liegenden Brückenelemente überqueren die Leiter des anderen Spulenpaars jeweils an Stellen, wo sich ein Diagonal-Leiterelement befindet. Die Spulenpaare A und B sind zur besseren Unterscheidbarkeit in unterschiedlichen Strichstärken gezeichnet.

In Fig. 2.a) ist das Spulenpaar A aus der HF-Spulenanordnung gemäß Fig. 1 zur besseren Sichtbarkeit seiner Elemente separat und ohne die hochfrequenzmäßige Verschaltung nochmals dargestellt. Die Bogen-Leiterelemente 21 und 22, sowie die Längs-Leiterelemente 11 und 12 sind durch diagonal verlaufende Leiterelemente zur Sattelspule A' verbunden. Die Bogen-Leiterelemente 23 und 24, sowie die Längs-Leiterelemente 13 und 14 sind durch diagonal verlaufende Leiterelemente zur Sattelspule A" verbunden.

In Fig. 2.b) ist das Spulenpaar B aus der HF-Spulenanordnung gemäß Fig. 1 zur besseren Sichtbarkeit seiner Elemente separat und ohne die hochfrequenzmäßige Verschaltung nochmals dargestellt. Die Bogen-Leiterelemente 27 und 28, sowie die Längs-Leiterelemente 17 und 18 sind über Brückenelemente 30 zur Sattelspule B' verbunden. Die Bogen-Leiterelemente 25 und 26, sowie die Längs-Leiterelemente 15 und 16 sind über insgesamt acht Brückenelemente 30 zur Sattelspule B" verbunden.

### Bezugszeichenliste

- 1: Mantelfläche (eines Kreiszylinders)
- 2: Zylinderachse
- 10: HF-Spulenanordnung
- 11, 12, 13, 14, 15, 16, 17, 18: Längs-Leiterelemente
- 21, 22, 23, 24, 25, 26, 27, 28: Bogen-Leiterelemente
- 30: Brückenelement
- 40: Diagonal-Leiterelement

- A: erstes Spulenpaar
- B: zweites Spulenpaar
- A', A", B', B": Sattelspulen

## Patentansprüche

1. MAS-NMR-Magnetresonanzgerät mit einer HF-Spulenanordnung (10) zur Erzeugung mindestens zweier unabhängiger magnetischer Wechselfelder in einem Untersuchungsvolumen des MAS-NMR-Magnetresonanzgeräts, umfassend ein erstes Spulenpaar (A) aus Sattelspulen mit Längs-Leiterelementen und Bogen-Leiterelementen die entlang einer gemeinsamen geometrischen Mantelfläche (1) eines Kreiszylinders mit einer Zylinderachse (2) angeordnet sind, wobei die HF-Spulenanordnung (10) ein zweites Spulenpaar (B) aus Sattelspulen mit Längs-Leiterelementen und Bogen-Leiterelementen umfasst, die entlang der Mantelfläche (1) angeordnet sind,
wobei eine erste Gruppe der Bogen-Leiterelemente und Längs-Leiterelemente hochfrequenzmäßig zur Bildung des ersten Spulenpaars (A) mit sich in Bezug auf die Zylinderachse gegenüberliegenden Sattelspulen (A', A") verschaltet sind, wobei eine zweite Gruppe der Bogen-Leiterelemente und Längs-Leiterelemente hochfrequenzmäßig zur Bildung des zweiten Spulenpaars (B) mit sich in Bezug auf die Zylinderachse gegenüberliegenden, Sattelspulen (B', B") verschaltet sind,
wobei die axiale Position und die radiale Ausdehnung bezüglich der Zylinderachse des ersten (A) und des zweiten (B) Spulenpaars gleich sind,
dass sich das erste und zweite Spulenpaar in azimutaler Richtung überlappen, und
wobei in den Sattelspulen (A', A", B', B") des ersten und/oder zweiten Spulenpaars (A, B) Brückenelemente angeordnet sind, welche ein Leiterelement des jeweils anderen Spulenpaars (B, A) überqueren,
wobei die beiden Spulenpaare zur Erzeugung magnetischer Wechselfelder zweier unterschiedlicher Frequenzen ausgelegt sind,
wobei eine Vorrichtung zur Erzeugung eines statischen Magnetfelds mit einer Magnetfeldrichtung im Untersuchungsvolumen des MAS-NMR-Magnetresonanzgeräts und eine Anordnung zur Positionierung einer Messsonde in einem vorgegebenen Winkel zum statischen Magnetfeld vorhanden sind,
wobei die Zylinderachse in einem Winkel zwischen 50° und 60° zur Magnetfeldrichtung angeordnet ist, und
wobei die Spulenachse des ersten Spulenpaars (A) und die Spulenachse des zweiten Spulenpaars (B) die durch die Magnetfeldrichtung und die Zylinderachse aufgespannte Ebene jeweils in einem Winkel zwischen 40° und 50° schneiden.

2. MAS-NMR-Magnetresonanzgerät nach Anspruch 1, wobei mindestens eines der Brückenelemente als elektrisch leitendes Element ausgebildet ist.

3. MAS-NMR-Magnetresonanzgerät nach einem der Ansprüche 1 oder 2, wobei mindestens eines der Brückenelemente als Kondensator, insbesondere als Keramik-Vielschicht-Kondensator-Chip, ausgebildet ist.

4. MAS-NMR-Magnetresonanzgerät nach einem der Ansprüche 1 bis 3, wobei mindestens ein Spulenpaar (A, B) Diagonal-Leiterelemente umfasst, die je entlang einer Schraubenlinie auf der Mantelfläche ausgedehnt sind.

5. MAS-NMR-Magnetresonanzgerät nach Anspruch 4, wobei vorzugsweise diagonal angeordnete Brückenelemente des einen Spulenpaars jeweils Diagonal-Leiterelemente des anderen Spulenpaars überqueren.

6. MAS-NMR-Magnetresonanzgerät nach einem der Ansprüche 1 bis 5, wobei Bogen-Leiterelemente des ersten Spulenpaars (A) und Bogen-Leiterelemente des zweiten Spulenpaars (B) axial aufeinander ausgerichtet sind.

7. MAS-NMR-Magnetresonanzgerät nach einem der Ansprüche 1 bis 6, wobei der azimutale Öffnungswinkel der Sattelspulen (A', A", B', B") mindestens eines Spulenpaars zwischen 100° und 140°, insbesondere 120°, beträgt.

8. MAS-NMR-Magnetresonanzgerät nach einem der Ansprüche 1 bis 7, wobei die Spulenpaare (A, B) in Bezug aufeinander um 90° um die Zylinderachse gedreht angeordnet sind.

9. MAS-NMR-Magnetresonanzgerät nach einem der Ansprüche 1 bis 8, wobei die Leiterelemente des ersten Spulenpaars (A) und des zweiten Spulenpaars (B) die gleiche Form haben und in gleicher Form angeordnet sind.

10. MAS-NMR-Magnetresonanzgerät nach einem der Ansprüche 1 bis 9 auf einem Spulenträger mit einer Außenfläche, die abschnittsweise mit der geometrischen Mantelfläche des Kreiszylinders identisch ist.

11. MAS-NMR-Magnetresonanzgerät nach Anspruch 10, wobei der Spulenträger mindestens eines der folgenden Materialien umfasst: Saphir, Glas, Quarz, ein Fluoropolymer, insbesondere Polytetrafluoräthylen, eine Keramik, insbesondere Aluminiumoxid, Magnesiumoxid oder Bornitrid.

12. MAS-NMR-Magnetresonanzgerät nach einem der Ansprüche 1 bis 11, wobei die Sattelspulen formstabile freitragende Spulen sind.

13. MAS-NMR-Magnetresonanzgerät nach einem der Ansprüche 1 bis 12, wobei die HF-Spulenanordnung zusätzlich eine Solenoidspule mit Achsenrichtung koaxial zur Zylinderachse umfasst.

14. MAS-NMR-Magnetresonanzgerät nach einem der Ansprüche 1 bis 13, wobei in zumindest einem Spulenpaar (A; B) die beiden Sattelspulen (A', A"; B', B") in Serie geschaltet sind.

15. MAS-NMR-Magnetresonanzgerät nach einem der Ansprüche 1 bis 14, wobei in zumindest einem Spulenpaar (A; B) die beiden Sattelspulen (A', A"; B', B") parallel geschaltet sind.

16. MAS-NMR-Magnetresonanzgerät nach einem der Ansprüche 1 bis 15, wobei die Messsonde mindestens zwei HF-Eingänge aufweist, wobei ein erster HF-Eingang über ein erstes Abstimmnetzwerk hochfrequenzmäßig an das erste Spulenpaar (A) angekoppelt ist und wobei ein zweiter HF-Eingang über ein zweites Abstimmnetzwerk hochfrequenzmäßig an das zweite Spulenpaar (B) angekoppelt ist.

17. MAS-NMR-Magnetresonanzgerät nach Anspruch 16, wobei zumindest eines der Abstimmnetzwerke über mindestens ein serielles kapazitives Element mit dem jeweiligen Spulenpaar verbunden ist.

18. MAS-NMR-Magnetresonanzgerät nach Anspruch 17 oder 18, wobei zumindest eines der Abstimmnetzwerke galvanisch getrennt, insbesondere transformatorisch, an das jeweilige Spulenpaar angekoppelt ist.

19. MAS-NMR-Magnetresonanzgerät nach einem der Ansprüche 16 bis 18 mit mindestens einem Drehlager mit zur Zylinderachse koaxialer Drehachse, wobei das mindestens eine Drehlager ausgelegt ist zur drehbaren Halterung einer Probe innerhalb der HF-Spulenanordnung.

20. MAS-NMR-Magnetresonanzgerät nach einem der Ansprüche 1 bis 19, wobei die Zylinderachse in einem Winkel zwischen 54.7° und 54.8° zur Magnetfeldrichtung angeordnet ist.

21. MAS-NMR-Magnetresonanzgerät nach Anspruch 20, wobei die Spulenachse des ersten Spulenpaars (A) und die Spulenachse des zweiten Spulenpaars (B) die durch die Magnetfeldrichtung und die Zylinderachse aufgespannte Ebene jeweils in einem 45° Winkel schneiden.

22. MAS-NMR-Magnetresonanzgerät nach einem der Ansprüche 1 bis 21, wobei das erste (A) und das zweite (B) Spulenpaar je mit einer ersten und einer zweiten HF-Sendeeinheit gesteuert wirkverbunden sind.

23. Verfahren zur Durchführung einer NMR-Messung an einer Probe unter Verwendung eines MAS-NMR-Magnetresonanzgeräts nach einem der Ansprüche 1 bis 22, wobei
- die Probe innerhalb der Mantelfläche des Zylinders angeordnet wird, und
- beide Spulenpaare (A, B) gleichzeitig mit HF-Leistung beaufschlagt werden.

## Claims

1. MAS NMR magnetic resonance apparatus comprising an RF coil assembly (10) for generating at least two independent alternating magnetic fields in an examination volume of the MAS NMR magnetic resonance apparatus, comprising a first coil pair (A) of saddle coils having longitudinal conductor elements and curved conductor elements, which are arranged along a common geometric lateral surface (1) of a circular cylinder having a cylinder axis (2),
wherein the RF coil assembly (10) comprises a second coil pair (B) of saddle coils having longitudinal conductor elements and curved conductor elements, which are arranged along the lateral surface (1),
wherein a first group of curved conductor elements and longitudinal conductor elements are interconnected at a high frequency to form the first coil pair (A) with saddle coils (A', A"), which are opposite each other relative to the cylinder axis,
wherein a second group of curved conductor elements and longitudinal conductor elements are interconnected at a high frequency to form the second coil pair (B) with saddle coils (B', B"), which are opposite each other relative to the cylinder axis,
wherein the axial position and radial extent relative to the cylinder axis of the first (A) and second (B) coil pairs are equal,
the first and second coil pair overlap in the azimuthal direction, and
wherein bridge elements, each of which crosses over a conductor element of the other coil pair (B, A), are arranged in the saddle coils (A, A", B', B") of the first and/or second coil pair (A, B),
wherein the two coil pairs are designed to generate alternating magnetic fields at two different frequencies, wherein a device for generating a static magnetic field in a magnetic field direction in the examination volume of the MAS NMR magnetic resonance apparatus and an arrangement for positioning a measuring probe at a predetermined angle to the static magnetic field are provided,
wherein the cylinder axis is arranged at an angle of between 50° and 60° to the direction of the magnetic field, and
wherein the coil axis of the first coil pair (A) and the coil axis of the second coil pair (B) intersect with the plane spanned by the magnetic field direction and the cylinder axis, in each case at an angle of between 40° and 50°.

2. The MAS NMR magnetic resonance apparatus according to claim 1, wherein at least one of the bridge elements is designed as an electrically conductive element.

3. The MAS NMR magnetic resonance apparatus according to either claim 1 or claim 2, wherein at least one of the bridge elements is designed as a capacitor, in particular as a ceramic multilayer capacitor chip.

4. The MAS NMR magnetic resonance apparatus according to one of claims 1 to 3, wherein at least one coil pair (A, B) comprises diagonal conductor elements, which are each extended along a helical line on the lateral surface.

5. The MAS NMR magnetic resonance apparatus according to claim 4, wherein bridge elements of the one coil pair, which are preferably arranged diagonally, cross over diagonal conductor elements of the other coil pair in each case.

6. The MAS NMR magnetic resonance apparatus according to one of claims 1 to 5, wherein curved conductor elements of the first coil pair (A) and curved conductor elements of the second coil pair (B) are oriented axially toward each other.

7. The MAS NMR magnetic resonance apparatus according to one of claims 1 to 6, wherein the azimuthal opening angle of the saddle coils (A', A", B', B") of at least one coil pair is between 100° and 140°, in particular 120°.

8. The MAS NMR magnetic resonance apparatus according to one of claims 1 to 7, wherein the coil pairs (A, B) are arranged such that they are rotated 90° to each other about the cylinder axis.

9. The MAS NMR magnetic resonance apparatus according to one of claims 1 to 8, wherein the conductor elements of the first coil pair (A) and of the second coil pair (B) are the same shape and are arranged in the same shape.

10. The MAS NMR magnetic resonance apparatus according to one of claims 1 to 9, on a coil support comprising an outer surface, which is identical in sections to the geometric lateral surface of the circular cylinder.

11. The MAS NMR magnetic resonance apparatus according to claim 10, wherein the coil support comprises at least one of the following materials: sapphire, glass, quartz, a fluoropolymer, in particular polytetrafluoroethylene, a ceramic, in particular alumina, magnesium oxide or boron nitride.

12. The MAS NMR magnetic resonance apparatus according to one of claims 1 to 11, wherein the saddle coils are dimensionally stable, self-supporting coils.

13. The MAS NMR magnetic resonance apparatus according to one of claims 1 to 12, wherein the RF coil assembly additionally comprises a solenoid coil having an axial direction that is coaxial with the cylinder axis.

14. The MAS NMR magnetic resonance apparatus according to one of claims 1 to 13, wherein the two saddle coils (A', A"; B', B") are connected in series in at least one coil pair (A; B).

15. The MAS NMR magnetic resonance apparatus according to one of claims 1 to 14, wherein the two saddle coils (A', A"; B', B") are connected in parallel in at least one coil pair (A; B).

16. The MAS NMR magnetic resonance apparatus according to one of the claims 1 to 15, wherein the measuring probe has at least two RF inputs, wherein a first RF input is coupled to the first coil pair (A) at a high frequency via a first tuning network, and wherein a second RF input is coupled to the second coil pair (B) at a high frequency via a second tuning network.

17. The MAS NMR magnetic resonance apparatus according to claim 16, wherein at least one of the tuning networks is connected to the relevant coil pair via at least one serial capacitive element.

18. The MAS NMR magnetic resonance apparatus according to either claim 17 or claim 18, wherein at least one of the tuning networks is coupled to the relevant coil pair in a galvanically isolated, in particular transformational, way.

19. The MAS NMR magnetic resonance apparatus according to one of claims 16 to 18, comprising at least one pivot bearing having an axis of rotation that is coaxial with the cylinder axis, wherein the at least one pivot bearing is designed to provide rotary support for a sample within the RF coil assembly.

20. The MAS NMR magnetic resonance apparatus according to one of the claims 1 to 19, wherein the cylinder axis is arranged at an angle of between 54.7° and 54.8° to the direction of the magnetic field.

21. The MAS NMR magnetic resonance apparatus according to claim 20, wherein the coil axis of the first coil pair (A) and the coil axis of the second coil pair (B) intersect with the plane spanned by the magnetic field direction and the cylinder axis, in each case at an angle of 45°.

22. The MAS NMR magnetic resonance apparatus according to one of the claims 1 to 21, wherein the first (A) and second (B) coil pairs are each controllably operatively coupled to a first and a second RF transmitting unit.

23. A method for performing an NMR measurement on a sample using an MAS NMR magnetic resonance apparatus according to one of claims 1 to 22, wherein
- the sample is arranged within the lateral surface of the cylinder, and
- RF power is applied to both coil pairs (A, B) simultaneously.

## Revendications

1. Appareil de résonance magnétique RMN MAS avec un agencement de bobines HF (10) pour générer au moins deux champs magnétiques alternatifs indépendants dans un volume d'examen de l'appareil de résonance magnétique RMN MAS, comprenant une première paire de bobines (A) formée de bobines en selle de cheval avec des éléments conducteurs longitudinaux et des éléments conducteurs en arc qui sont disposés le long d'une surface extérieure géométrique commune (1) d'un cylindre circulaire ayant un axe de cylindre (2), dans lequel l'agencement de bobines HF (10) comprend une deuxième paire de bobines (B) formée de bobines en selle de cheval avec des éléments conducteurs longitudinaux et des éléments conducteurs en arc qui sont disposés le long de la surface extérieure (1),
dans lequel un premier groupe d'éléments conducteurs en arc et d'éléments conducteurs longitudinaux sont connectés du point de vue des hautes fréquences pour former la première paire de bobines (A) avec des bobines en selle de cheval (A', A") se faisant face par rapport à l'axe de cylindre,
dans lequel un deuxième groupe d'éléments conducteurs en arc et d'éléments conducteurs longitudinaux sont connectés du point de vue des hautes fréquences pour former la deuxième paire de bobines (B) avec des bobines en selle de cheval (B', B") se faisant face par rapport à l'axe de cylindre,
dans lequel la position axiale et l'extension radiale par rapport à l'axe de cylindre de la première (A) et de la deuxième (B) paire de bobines sont les mêmes,
dans lequel la première et la deuxième paire de bobines se chevauchent dans la direction azimutale, et
dans lequel, dans les bobines en selle de cheval (A', A", B', B") de la première et/ou de la deuxième paire de bobines (A, B) sont disposés des éléments en pont qui croisent un élément conducteur de l'autre paire de bobines respective (B, A),
dans lequel les deux paires de bobines sont conçues pour générer des champs magnétiques alternatifs de deux fréquences différentes,
dans lequel un dispositif pour générer un champ magnétique statique ayant une direction de champ magnétique dans le volume d'examen de l'appareil de résonance magnétique RMN MAS et un agencement pour positionner une sonde de mesure selon un angle prédéfini par rapport au champ magnétique statique sont prévus,
dans lequel l'axe de cylindre est disposé selon un angle compris entre 50° et 60° par rapport à la direction du champ magnétique, et
dans lequel l'axe de bobine de la première paire de bobines (A) et l'axe de bobine de la deuxième paire de bobines (B) coupent chacun le plan défini par la direction du champ magnétique et l'axe de cylindre selon un angle compris entre 40° et 50°.

2. Appareil de résonance magnétique RMN MAS selon la revendication 1, dans lequel au moins un des éléments en pont est réalisé sous la forme d'un élément électriquement conducteur.

3. Appareil de résonance magnétique RMN MAS selon l'une des revendications 1 ou 2, dans lequel au moins un des éléments en pont est réalisé sous la forme d'un condensateur, en particulier d'un condensateur à puce céramique multicouche.

4. Appareil de résonance magnétique RMN MAS selon l'une des revendications 1 à 3, dans lequel au moins une paire de bobines (A, B) comprend des éléments conducteurs diagonaux qui s'étendent chacun le long d'une ligne hélicoïdale sur la surface extérieure.

5. Appareil de résonance magnétique RMN MAS selon la revendication 4, dans lequel des éléments en pont, disposés de préférence en diagonale, d'une paire de bobines croisent des éléments conducteurs en diagonale de l'autre paire de bobines.

6. Appareil de résonance magnétique RMN MAS selon l'une des revendications 1 à 5, dans lequel des éléments conducteurs en arc de la première paire de bobines (A) et des éléments conducteurs en arc de la deuxième paire de bobines (B) sont alignés axialement les uns avec les autres.

7. Appareil de résonance magnétique RMN MAS selon l'une des revendications 1 à 6, dans lequel l'angle d'ouverture azimutal des bobines en selle de cheval (A', A", B', B") d'au moins une paire de bobines est compris entre 100° et 140°, et est en particulier de 120°.

8. Appareil de résonance magnétique RMN MAS selon l'une des revendications 1 à 7, dans lequel les paires de bobines (A, B) sont disposées en étant tournées de 90° l'une par rapport à l'autre autour de l'axe de cylindre.

9. Appareil de résonance magnétique RMN MAS selon l'une des revendications 1 à 8, dans lequel les éléments conducteurs de la première paire de bobines (A) et de la deuxième paire de bobines (B) ont la même forme et sont disposés sous la même forme.

10. Appareil de résonance magnétique RMN MAS selon l'une des revendications 1 à 9 sur un porte-bobines dont la surface extérieure est identique sur certaines parties à la surface extérieure géométrique du cylindre circulaire.

11. Appareil de résonance magnétique RMN MAS selon la revendication 10, dans lequel le porte-bobines comprend au moins l'un des matériaux suivants : saphir, verre, quartz, un fluoropolymère, en particulier du polytétrafluoroéthylène, une céramique, en particulier de l'oxyde d'aluminium, de l'oxyde de magnésium ou du nitrure de bore.

12. Appareil de résonance magnétique RMN MAS selon l'une des revendications 1 à 11, dans lequel les bobines en selle de cheval sont des bobines autoportantes dimensionnellement stables.

13. Appareil de résonance magnétique RMN MAS selon l'une des revendications 1 à 12, dans lequel l'agencement de bobines HF comprend en outre un solénoïde ayant une direction axiale coaxiale à l'axe de cylindre.

14. Appareil de résonance magnétique RMN MAS selon l'une des revendications 1 à 13, dans lequel, dans au moins une paire de bobines (A ; B), les deux bobines en selle de cheval (A', A" ; B', B") sont connectées en série.

15. Appareil de résonance magnétique RMN MAS selon l'une des revendications 1 à 14, dans lequel, dans au moins une paire de bobines (A ; B), les deux bobines en selle de cheval (A', A" ; B', B") sont connectées en parallèle.

16. Appareil de résonance magnétique RMN MAS selon l'une des revendications 1 à 15, dans lequel la sonde de mesure présente au moins deux entrées HF, dans lequel une première entrée HF est couplée à la première paire de bobines (A) du point de vue des hautes fréquences par un premier réseau d'accord et dans lequel une deuxième entrée HF est couplée à la deuxième paire de bobines (B) du point de vue des hautes fréquences par un deuxième réseau d'accord.

17. Appareil de résonance magnétique RMN MAS selon la revendication 16, dans lequel au moins un des réseaux d'accord est relié à la paire de bobines respective par au moins un élément capacitif série.

18. Appareil de résonance magnétique RMN MAS selon la revendication 17 ou 18, dans lequel au moins un des réseaux d'accord est couplé à la paire de bobines respective d'une manière séparée galvaniquement, en particulier par transformateur.

19. Appareil de résonance magnétique RMN MAS selon l'une des revendications 16 à 18 avec au moins un palier rotatif ayant un axe de rotation coaxial à l'axe de cylindre, dans lequel ledit au moins un palier rotatif est conçu pour maintenir de façon rotative un échantillon à l'intérieur de l'agencement de bobines HF.

20. Appareil de résonance magnétique RMN MAS selon l'une des revendications 1 à 19, dans lequel l'axe de cylindre est disposé selon un angle compris entre 54,7° et 54,8° par rapport à la direction du champ magnétique.

21. Appareil de résonance magnétique RMN MAS selon la revendication 20, dans lequel l'axe de bobine de la première paire de bobines (A) et l'axe de bobine de la deuxième paire de bobines (B) coupent chacun le plan défini par la direction du champ magnétique et l'axe de cylindre selon un angle de 45°.

22. Appareil de résonance magnétique RMN MAS selon l'une des revendications 1 à 21, dans lequel la première (A) et la deuxième (B) paire de bobines sont chacune reliées fonctionnellement de manière commandée à une première et une deuxième unité d'émission HF.

23. Procédé pour effectuer une mesure RMN sur un échantillon en utilisant un appareil de résonance magnétique RMN MAS selon l'une des revendications 1 à 22, dans lequel
- l'échantillon est disposé à l'intérieur de la surface extérieure du cylindre, et
- les deux paires de bobines (A, B) sont alimentées simultanément en puissance HF.
